# EUROPÄISCHE PATENTSCHRIFT

(11) **EP 0 564 918 B1**
(45) Veröffentlichungstag und Bekanntmachung des Hinweises auf die Patenterteilung: **03.06.1998**
(21) Anmeldenummer: 93104970.4
(22) Anmeldetag: 25.03.1993
(51) Int. Cl.: G03F 7/033, C08F 287/00, C08F 2/48

(54) **Lichthärtbares elastomeres Gemisch und daraus erhaltenes Aufzeichnungsmaterial für die Herstellung von Reliefdruckplatten**
Light-curable elastomeric mixture and recording material for flexographic printing plates obtained therefrom
Composition élastomère photodurcissable et matériau d'enregistrement obtenu de cela pour la production des plaques d'impression en relief

(30) Priorität: 04.04.1992 DE 4211390
(43) Veröffentlichungstag der Anmeldung: 13.10.1993
(73) Patentinhaber: Agfa-Gevaert AG, 51373 Leverkusen (DE)
(72) Erfinder: Gries, Willi-Kurt, Dr., W-6200 Wiesbaden (DE); Faust, Raimund-Josef, Dr., W-6200 Wiesbaden (DE)

(56) Entgegenhaltungen:
- DE-U- 9 016 662
- GB-A- 2 171 107
- CHEMICAL ABSTRACTS, vol. 111, no. 4, 24. Juli 1989, Columbus, Ohio, US; abstract no. 31381q, & JP-A-1 049 036 (JAPAN SYNTHETIC RUBBER CO.,LTD.) 23. Februar 1989

## Beschreibung

Die Erfindung betrifft ein lichthärtbares, negativ arbeitendes Gemisch und ein daraus erhaltenes Aufzeichnungsmaterial, das für die Herstellung von elastischen Reliefdruckplatten geeignet ist.

Lichthärtbare, negativ arbeitende Gemische sind bekannt und enthalten gewöhnlich ein elastomeres Bindemittel, eine radikalisch polymerisierbare Verbindung und einen durch aktinische Strahlung aktivierbaren Polymerisationsinitiator. Derartige Gemische, die z. B. in der DE-A 22 15 090 (= GB-A 1 366 769) beschrieben sind, lassen sich nach der Belichtung nur mit organischen Lösemitteln zum Reliefbild entwickeln.

In den DE-A 30 03 011 (= ZA 80/506), DE-A 27 25 730 (= US-A 4 042 386), DE-A 33 22 994 (= US-A 4 554 240) und EP-A 0 130 828 werden zwar wäßrig entwickelbare Aufzeichnungsmaterialien auf der Basis teilverseifter Polyvinylacetat-Derivate beschrieben, jedoch ist die Wasserresistenz solcher Systeme gering, so daß ein Einsatz mit wasserverdünnbaren Druckfarben nicht möglich ist. Deshalb werden in den DE-A 30 12 841 (= US-A 4 272 608), DE-A 35 43 646 (= US-A 4 916 045), EP-A 0 183 552, 0 251 228, 0 273 393, 0 277 418 und 0 261 910, GB-A 2 179 360, US-A 4 446 220 und 4 517 279 Aufzeichnungsmaterialien auf der Basis carboxylgruppenhaltiger Dien-Elastomere vorgeschlagen. Aminogruppenhaltige Bindemittel gemäß GB-A 2 171 107 und DE-A 36 04 402 (= US-A 4 952 481) finden dagegen weitaus weniger Verwendung.

Sowohl die sauren als auch die basischen Bindemittel enthalten die für eine Entschichtung entscheidenden hydrophilen, ionisierbaren Gruppen in mehr oder weniger statistischer Verteilung. Ist in diesen Systemen der Anteil solcher hydrophilen Einheiten niedrig so kann eine wäßrige Entwickelbarkeit nur schwer realisiert werden und es ist erforderlich, einen hohen Anteil polarer Monomere bzw. Hilfsstoffe zuzusetzen, die ihrerseits einen hohen Kaltfluß des unbelichteten Materials zur Folge haben. Eine Erhöhung des Anteils an polaren Gruppen ergibt zwar eine verbesserte wäßrige Entwickelbarkeit, jedoch verschlechtern sich systembedingt die gummielastischen Eigenschaften dieser Materialien. Darüber hinaus reduziert sich die Resistenz gegenüber wasserenthaltenden Druckfarben.

In der DE-A 40 32 238 werden lichthärtbare elastomere Gemische beschrieben, die als elastomeres Bindemittel ein Blockcopolymerisat enthalten, das aus den Segmenten A, B, C und X aufgebaut ist, wobei
- A: einen hydrophoben weichen Block mit einer Glastemperatur T_{g} von weniger als -30 °C,
- B: einen hydrophilen harten Block, der saure Gruppen, vorzugsweise Carboxygruppen, enthält und eine Glastemperatur T_{g} von mehr als +30 °C aufweist,
- C: einen hydrophoben harten Block mit einer Glastemperatur T_{g} von mehr als +50 °C,
- X: eine Einheit, gebildet aus einer Verbindung mit zwei oder mehreren Vinyl- oder Isopropenylgruppen oder einen aus solchen Verbindungen entstandenen Homopolymerisat-Block, der in der Regel verzweigt bzw. vernetzt ist, bedeuten.

Aufgabe der Erfindung war es, lichtempfindliche, elastomere Gemische vorzuschlagen, die unter milden Bedingungen wäßrig entwickelbar sind, jedoch eine hohe Resistenz gegenüber wasserverdünnbaren Druckfarben besitzen.

Diese Aufgabe konnte nun überraschenderweise durch die Verwendung von amphiphilen basischen Blockcopolymerisaten als Bindemittel gelöst werden. Als "amphiphile" Blockcopolymerisate werden hier solche Blockcopolymerisate bezeichnet, die sowohl wasseranziehende (hydrophile) als auch wasserabstoßende (hydrophobe) Abschnitte haben und daher Tensidcharakter besitzen.

Gegenstand der Erfindung ist ein lichthärtbares elastomeres Gemisch, das als wesentliche Bestandteile
a) ein amphiphiles elastomeres Bindemittel bzw. ein Gemisch solcher Bindemittel,
b) eine radikalisch polymerisierbare, mit dem Bindemittel verträgliche Verbindung mit mindestens einer endständigen, ethylenisch ungesättigten Gruppe und einem Siedepunkt bei Normaldruck oberhalb 100 °C und
c) eine Verbindung oder eine Verbindungskombination, die unter Einwirkung von aktinischem Licht die Polymerisation der Verbindung (b) einzuleiten vermag,
enthält, wobei das Bindemittel aus den Segmenten A, B, C und X aufgebaut ist, und
- A: einen hydrophoben weichen Block mit einer Glastem peratur T_{g} von unter -30 °C,-
- B: einen hydrophilen, basische Gruppen enthaltenden harten Block mit einer Glastemperatur T_{g} von über +10 °C,
- C: einen hydrophoben harten Block mit einer Glastemperatur T_{g} von über +50 °C und
- X: eine Einheit, gebildet aus einer Verbindung mit zwei oder mehreren Vinyl- oder Isopropenylgruppen oder einem aus solchen Verbindungen entstandenen Homopolymerisatblock, der verzweigt oder vernetzt ist,
bedeuten.

Diese Blockcopolymerisate können auf mannigfache Weise aufgebaut sein, je nach dem, welche und wie viele dieser Segmente in dem Copolymerisat enthalten sind und wie diese Segmente miteinander verknüpft sind. Diese Blockcopolymerisate können beispielsweise folgende Strukturen haben: A-B, C-A-B, C-A-C-B, AₙXBₙ, (A-B)ₙX, CₙX(A-B)ₙ, (C-A)ₙXBₙ, (C-A-B)ₙX, CₙX(A-C-B)ₙ, (C-A) ₙX(C-B)ₙ, (C-A-C)ₙXBₙ und (C-A-C-B)ₙX. Ferner sind symmetrische B-A-B- und B-C-A-C-B-Blockcopolymerisate und verzweigte Vertreter entsprechend X(B-A-B)ₙX, BₙXAₙXBₙ, X(B-C-A-C-B)ₙX, (B-C)ₙXAₙX(C-B)ₙ sowie BₙX(C-A-C)ₙXBₙ als Bindemittel verwendbar.

In diesen Formeln haben die Symbole A, B, C und X die oben genannten Bedeutungen, und n gibt das Verhältnis von A/B/C-Homopolymer-Blöcken zu dem vernetzten Homopolymerisat-Block X an.

Als Monomere für die Blockpolymerisate A sind konjugierte Diene, wie 1,3-Butadien, Isopren, 2,3-Dimethyl-1,3-butadien, 1,3-Pentadien, 2-Methyl-3-ethyl-1,3-butadien, 3-Methyl-1,3-Pentadien, 2-Methyl-3-ethyl-1,3-pentadien, 2-Ethyl-1,3-Pentadien, 1,3-Hexadien, 2-Methyl-1,3-hexadien, 1,3-Heptadien, 1,3-Octadien, 3,4-Dimethyl-1,3-hexadien und 2-Phenyl-1,3-butadien, in Betracht. Der Einsatz von Gemischen geeigneter Diene bzw. die Anwendung anderer anionisch polymerisierbarer konjugierter Diene mit 4 bis 12 Kohlenstoffatomen kommen ebenfalls in Betracht. Bevorzugt werden Isopren und 1,3-Butadien verwendet.

Die Blöcke B resultieren aus ethylenisch ungesättigten Amino-Verbindungen wie die Derivate des Vinylpyridins, Amino-funktionalisierte Acrylate und mit Aminogruppen substituierte Vinylaromaten. Die Aminogruppen liegen dabei als tertiäre Aminogruppen vor. Primäre oder sekundäre Aminogruppen können vorteilhafterweise durch Schutzgruppen, beispielsweise durch Alkyl-Silyl-Gruppen, blockiert werden, so daß der anionisch initiierte Polymerisationsvorgang ohne Kettenabbruch ablaufen kann. Bevorzugt werden Dimethylaminoalkyl-Methacrylate eingesetzt. Die basischen Gruppen in den Blöcken B sind daher bevorzugt Amino-, Alkylamino- oder Dialkylaminogruppen.

Als Monomere für die Segmente C sind Vinylaromaten, insbesondere Styrol, Alkylstyrol oder Vinylnaphthalin geeignet, wobei Styrol besonders bevorzugt ist.

Als Vernetzer X kommen Monomere in Frage, die mindestens zwei Vinyl- oder Isopropenylgruppen enthalten. Vorteilhaft werden hier Di- und Trivinylbenzol sowie Verbindungen mit mindestens zwei Methacryloyloxy-Gruppen verwendet. Besonders bevorzugt sind 1,4-Divinylbenzol, 1,3-Diisopropenylbenzol, Ethylenglykoldimethacrylat und Trimethylolpropantrimethacrylat.

Die Herstellung der beschriebenen Blockpolymerisate erfolgt nach an sich bekannten Methoden. Verwiesen sei hier auf G. Sylvester und P. Müller in Houben-Weyl-Müller, Methoden der Organischen Chemie E 20/2, 798ff. (1987) und G. Schröder in Houben-Weyl-Müller, Methoden der Organischen Chemie E20/2, 1141ff. (1987) und S. Tazuke und S. Okamura, Encyclopedia of Polym. Sci. and Technol., Bd. 14, 637, John Wiley & Sons, New York-London - Toronto 1971 und A. Nazarov et al., Deposited Doc., VINITI 2486 - 74 (1974).

Zum Start der anionischen Polymerisation werden die üblichen lithiumorganischen Verbindungen R-Li verwendet, wobei unter R aliphatische, cycloaliphatische, aromatische oder gemischt aliphatisch aromatische Reste verstanden werden. Besonders erwähnenswert sind u. a. Methyllithium, Ethyllithium, (n-, sec.-, tert.-) Butyllithium, Isopropyllithium, Cyclohexyllithium, Phenyllithium und p-Tolyllithium. Außerdem können bifunktionelle, in unpolaren Medien aktive Initiatoren, wie sie beispielsweise durch radikalische Kupplung von Diphenylethen mittels Li-Metall entstehen oder durch Reaktion von Diisopropenyl-Benzolen mit Li-organischen Verbindungen gebildet werden, Verwendung finden. Bevorzugt zum Einsatz kommen sec.- bzw. n-BuLi sowie 1,4-Dilithio-1,1,4,4-tetraphenylbutan.

Die Copolymerisation wird unter den für die Handhabung von extrem feuchtigkeits- und sauerstoffempfindlichen Reagenzien üblichen Bedingungen durchgeführt, d. h. insbesondere, daß unter getrockneter Inertgasatmosphäre, z. B. unter einer Stickstoff- oder Argonatmosphäre, gearbeitet werden muß. Als Lösemittel werden aliphatische, cycloaliphatische und aromatische Kohlenwasserstoffe, wie Isobutan, n-Pentan, Isooctan, Cyclopentan, Cyclohexan, Cycloheptan, Benzol, Toluol oder Xylol sowie Gemische dieser Solventien eingesetzt. Es ist häufig zweckmäßig, in Gegenwart dipolarer, aprotischer Lösemittel zu arbeiten, um eine regioselektive Reaktion der Monomeren zu gewährleisten und so den Anteil an Produkten aus Nebenreaktionen gering zu halten. (Eine Reaktion wird als "regioselektiv" bezeichnet, wenn von zwei oder mehreren zur Reaktion befähigten Zentren eines Moleküls eines weit überwiegend oder allein reagiert.) Besonders bevorzugte dipolare, aprotische Lösemittel sind Ether, wie beispielsweise Tetrahydrofuran, Dimethoxyethan oder Methylphenylether. Zur Erzielung bestimmter Eigenschaften der Produkte erweist es sich als günstig, die anionische Copolymerisation in unpolaren, aprotischen Solventien zu beginnen, jedoch mit fortschreitendem Umsatz die Polarität des Solvens durch Zugabe stärker polarer Ether zu erhöhen. Der Volumenanteil der Ether kann dabei bis über 95 % des Gesamtlösemittelvolumens betragen.

Die anionischen Kettenenden der A- bzw. C-Blöcke besitzen häufig eine zu starke Nucleophilie. Vor der weiteren Copolymerisation ist daher eine Reduzierung der Nucleophilie des anionischen Kettenendes zweckmäßig. Dies läßt sich durch den Zusatz von ungesättigten Verbindungen der allgemeinen Formel CH₂=CR¹R² erreichen. R¹ und R² stehen dabei für Aryl- bzw. Alkylarylgruppen, insbesondere jedoch für gegebenenfalls substituierte Phenylgruppen. Doch sind auch l-Phenyl-l-naphthylethen und seine Derivate brauchbar. Auch Styrole (R¹ = gegebenenfalls substituiertes Phenyl, R² = H oder C₁-C₆-Alkyl) sind geeignet, insbesondere wenn Styrol-Blockpolymerisate eingeführt werden sollen. Bevorzugt ist jedoch 1,1-Diphenylethen.

Die Blockcopolymerisation wird in bekannter Weise durch sequentielle Addition der verschiedenen Monomere durchgeführt. Die Reaktionsführung erfolgt dabei in der Art, daß die zum Aufbau von Folgeblöcken notwendigen Vinylverbindungen erst nach weitgehendem Umsatz der bereits vorhandenen Monomere zugegeben werden. Die Reaktionstemperatur wird zwischen -80 °C und 120 °C eingestellt. Vorzugsweise variieren die Temperaturen zwischen -72 °C und 60 °C. Es empfiehlt sich die zum Aufbau der B-Blöcke eingesetzten Monomere mindestens bei Raumtemperatur, jedoch besser bei -72 °C zu polymerisieren. Nach Beendigung des gewünschten Blockaufbaus können die polymeren Anionen durch Protonenquellen, wie Alkohole, Wasser, Ammoniumchlorid oder HCl, desaktiviert werden.

Die durch Gelpermeationschromatographie (GPC) bestimmten Molekulargewichte bewegen sich zwischen 2.000 g/mol und 2.000.000 g/mol, vorzugsweise zwischen 15.000 g/mol und 200.000 g/mol. Die Massenanteile der beteiligten Blockkomponenten variieren von 20 bis 99 Gew.-% für A, 1 bis 30 Gew.-% für B, 0 bis 80 Gew.-% für C und 0 bis 5 Gew.-%, vorzugsweise bis 3 Gew.-%, für X.

Die erfindungsgemäßen lichtempfindlichen Gemische enthalten im allgemeinen 20 bis 95 Gew.-%, vorzugsweise 30 bis 90 Gew.-%, des amphiphilen Bindemittels entweder ausschließlich oder in Verbindung mit anderen polymeren Materialien mit oder ohne funktionelle Gruppen. Solche polymeren Materialien können chlorierte oder chlorsulfonierte Polyethylenverbindungen, statistisch aufgebaute oder segmentierte Dien-Polymere bzw. Copolymere sowie geeignete durch Polyaddition oder Polykondensation herstellbare thermoplastische Elastomere sein. Sie enthalten weiterhin mindestens eine radikalisch polymerisierbare olefinisch ungesättigte Verbindung sowie mindestens einen Photoinitiator.

Geeignete Monomere mit einer oder mehreren polymerisierbaren olefinischen Doppelbindungen sind insbesondere Ester und Amide der Acryl-, Methacryl-, Fumar- und Maleinsäure sowie Gemische dieser Verbindungen. Zusätzlich können die zur Ester- oder Amidbildung benötigten Alkohole bzw. Amine weitere Funktionalitäten, z. B. Ethereinheiten, Hydroxy-, prim., sek. oder tert. Aminogruppen enthalten. Beispiele für zur Esterbildung geeignete Alkohole sind offenkettige und cyclische Alkanole, wie Butanol, Hexanol, Octanol, Decanol, Dodecanol, Octadecanol, 2-Ethylhexanol, Cyclohexanol oder Borneol, aber auch Hydroxygruppen enthaltende Oligo- oder Polybutadiene und Hydroxygruppen enthaltende Oligo- oder Polyisoprene. Weitere geeignete Alkohole sind Alkandiole, polyfunktionelle Alkohole, und ähnliche Verbindungen, z. B. 1,4-Butandiol oder 1,6-Hexandiol, (Poly)ethylenglykol oder (Poly)propylenglykol, Glycerin, Trimethylolpropan, Butantriol, Pentaerythrit u. a. Die di- oder polyfunktionellen Alkohole können dabei teilweise oder vollständig verestert sein. Weitere Beispiele ungesättigter Verbindungen sind spezielle Ester und Amide der (Meth)acrylsäure, z. B. Dimethylaminoethyl(meth)acrylat, Dimethylaminopropyl(meth)acrylamid, Maleinsäure-monomethacryloyloxyethylester (HEMAM), Pyromellitsäure-bis-2-methacryloyloxyethylester (HEMAP), 2-Butylaminoethyl(meth)acrylat, Ethylenbis(meth)acrylamid, Hexamethylenbis(meth)acrylamid, Diethylentriamintris(meth)acrylamid, Hydroxymethyl(meth)acrylamid und Bis-hydroxyethyl(meth)acrylamid.

Die Menge an Monomeren liegt im allgemeinen bei etwa 5 bis 70 Gew.-%, bevorzugt bei etwa 10 bis 50 Gew.-%, der nichtflüchtigen Bestandteile des Gemisches.

Als Photoinitiatoren für die erfindungsgemäßen Gemische kommen die bekannten Verbindungen in Frage, die eine hinreichende thermische Stabilität bei der Verarbeitung der Aufzeichnungsmaterialien sowie eine ausreichende Radikalbildung bei Belichtung zur Initiierung der Polymerisation der Monomeren aufweisen. Sie sollen Licht im Wellenlängenbereich von ca. 250 nm bis 500 nm unter Bildung von Radikalen absorbieren. Beispiele geeigneter Photoinitiatoren sind Acyloine und deren Derivate wie Benzoin, Benzoinalkylether, 1,2-Diketone und deren Derivate, z. B. Benzil, Benzilacetale wie Benzildimethylketal, Fluorenone, Thioxanthone, mehrkernige Chinone, Acridine und Chinoxaline, ferner Trichlormethyl-s-triazine, 2-Halogenmethyl-4-vinyl-[1,3,4]oxadiazol, mit Trichlormethylgruppen substituierte Halogenoxazole, Trihalogenmethylgruppen enthaltende Carbonylmethylenheterocyclen, Acylphosphinoxid-Verbindungen und andere phosphorhaltige Photoinitiatoren, z. B. 6-Acyl-6H-dibenzo[c,e][1,2]oxaphosphorin-6-oxide, insbesondere das 6-(2,4,6-Trimethylbenzoyl)-6H-dibenzo[c,e][1,2]oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10 Gew.-%, bevorzugt etwa 0,5 bis 5 Gew.-%, des Aufzeichnungsmaterials.

Oft ist es von Vorteil, dem Aufzeichnungsmaterial noch weitere Hilfs- und Zusatzstoffe zuzugeben, z. B. solche, die die thermische Polymerisation inhibieren, wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Die erfindungsgemäßen Gemische lassen sich für die Herstellung von Relief- und Flexodruckplatten durch Gießen aus Lösung oder Extrudieren und Kalandrieren zu Schichten einer Dicke von 0,02 bis 6 mm, vorzugsweise von 0,2 bis 3 mm, verarbeiten. Die Schicht kann auf die Oberfläche eines geeigneten Trägers laminiert oder eine Lösung der erfindungsgemäßen Gemische kann direkt auf einen Schichtträger aufgebracht werden.

Außer für die Herstellung von Reliefdruckplatten können die erfindungsgemäßen Gemische auch z. B. zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol oder Polyamid, oder eine abziehbare Deckfolie, z. B. aus Polyethylenterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Die erfindungsgemäßen Aufzeichnungsmaterialien können bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit Wasser, basischen oder sauren wäßrigen Lösungen erfolgen. Als basische Materialien kommen beispielsweise Hydroxide, Carbonate oder Hydrogencarbonate der Alkalimetalle, Ammoniak und organische Amine in Betracht, als saure Materialien ein- bzw. mehrbasige, in Wasser lösliche organische Säuren. Ferner können Netz- und Emulgiermittel sowie mit Wasser mischbare organische Lösemittel, z. B. aliphatische Alkohole, Ethylenglykole und Ethylenglykolmonoether, zugesetzt werden. Der Anteil der basischen bzw. sauren Komponenten an der Lösung beträgt im allgemeinen 0,01 bis 5 Gew.-%, bevorzugt 0,1 bis 1 Gew.-%. Der Anteil an organischem Lösemittel ist dabei kleiner als 40 Gew.-%, bevorzugt kleiner als 20 Gew.-%.

Alternativ können auch organische Lösemittel, wie aromatische Kohlenwasserstoffe, Chloralkane und Ketone als Entwickler verwendet werden. Beispiele dafür sind Toluol, Xylol, 1,1,1-Trichlorethan, Tetrachlorethylen, Methylisobutylketon u. a., die dabei auch in Kombination mit niederen Alkoholen, z. B. n-Butanol, eingesetzt werden können. Zweckmäßig werden die entwickelten Reliefformen bei Temperaturen bis 120 °C getrocknet und gegebenenfalls photochemisch oder chemisch nachbehandelt.

Die erfindungsgemäßen Aufzeichnungsmaterialien eignen sich besonders zur Herstellung von Druckformen, vor allem für den Flexodruck oder Flachdruck.

Die Erfindung wird durch die nachstehenden Beispiele erläutert. Wenn nichts anderes angegeben, stehen %-Angaben für Gew. -%-Angaben.

### Herstellung der Blockcopolymere

### Herstellungsbeispiel 1

In einer trockenen, mehrfach evakuierten und mit vorgetrocknetem Stickstoff belüfteten Glasapperatur werden 300 ml wasserfreies Toluol vorgelegt, 139 mmol trockenes Styrol hinzugefügt und mit 2,30 ml einer 1,6 M n-Butyllithium-Lösung in Hexan versetzt. Nach kurzer Zeit kommt die Polymerisation in Gang. Dann wird die Lösung noch 1 h im Wasserbad bei Raumtemperatur gerührt. Zur orangefarbenen Reaktionsmischung werden 1,50 mol Isopren gegeben. Nach 3 h Rühren im Wasserbad erfolgt die Zugabe von, bezogen auf den Starter, 2 Äquivalenten 1,1-Diphenylethen, es wird mit 300 ml Tetrahydrofuran (THF) verdünnt, 15 min bei Raumtemperatur gerührt und anschließend auf -72 °C abgekühlt. Die dunkelrote, zähflüssige Reaktionsmischung wird mit 186 mmol N,N-Dimethylaminoethylmethacrylat versetzt, 1 h bei -72 °C gerührt, und nach Zugabe von 2 ml Methanol sowie 1 Mol-% 2,6-Di-tert.-butyl-4-methylphenol aufgetaut. Die Reaktionslösung wird anschließend in das 10-fache Volumen Methanol eingesprüht. Das ausgefallene Polymere wird abgesaugt, gewaschen und getrocknet.
**1** S-I-DMAEMA (10/70/20 %), Ausbeute = 87 %, GPC (THF): Mp (RI) = 46000, D = 1,20

### Herstellungsbeispiele 2 und 3

In analoger Weise werden die Beispiele 2 und 3 hergestellt, jedoch wird nach Beendigung der Isopren-Polymerisation durch Zugabe einer entsprechenden Menge Styrol bei Raumtemperatur der zweite Styrol-Block innerhalb einer Stunde eingeführt.
**2** S-I-S-DMAEMA (8/74/8/10 %), Ausbeute = 81 %, GPC (THF): Mp (RI) = 129000, D = 1,13
**3** S-I-S-DMAEMA (8/64/8/20 %), Ausbeute = 95 %, GPC (THF): Mp (RI) = 41000, D = 1,02

### Vergleichsbeispiel 4

Ein vergleichbares Blockcopolymeres mit 4-Vinylpyridin als basische Komponente wurde in Anlehnung an die Beispiele 2 und 3 hergestellt. Anstatt Toluol wurde dabei Cyclohexan als Lösungsmittel verwendet. Die sterische Blockierung des reaktiven Kettenendes mit 1,1-Diphenylethen vor Zugabe der basischen Komponente war nicht erforderlich. Die eigentliche Polymerisation wurde bei Raumtemperatur über einen Zeitraum von 19 Stunden durchgeführt, wobei jedoch vor Zugabe des 4-Vinylpyridins und während der ersten Reaktionsstunde mit einem Eis/Wasser-Bad gekühlt wurde.
**4** S-I-S-4VP (8/64/8/20 %), Ausbeute = 93 %, GPC (THF): Mp (RI) = 70000, D = 1,22.

Die in den obigen Beispielen benutzten Abkürzungen, soweit nicht allgemein gebräuchlich, haben folgende Bedeutung:

| | |
|---|---|
| S | = Styrol |
| I | = Isopren |
| DMAEMA | = Dimethylaminoethylmethacrylat |
| MAA | = Methacrylsäure |
| 4VP | = 4-Vinylpyridin |

Die GPC-Untersuchungen wurden in Tetrahydrofuran mit Polystyrol-Standards als Bezugsmolekulargewicht durchgeführt.

### Beispiel 1 (Flexodruckplatte)

| | |
|---|---|
| 19,2 g | des gemäß Herstellungsbeispiel 1 synthetisierten S-I-DMAEMA-Blockcopolymeren mit einem Anteil von 10 % Styrol, 70 % Isopren und 20 % N,N-Dimethylaminoethylmethacrylat, |
| 2,85 g | Polyisopren (Kuraray: LIR 403), |
| 1,50 g | Maleinsäure-mono-2-acryloyloxyethylester, |
| 3,00 g | Tripropylenglykol-diacrylat, |
| 0,30 g | Benzildimethylketal, |
| 0,15 g | 2,6-Di-tert.-butyl-4-methylphenol und |
| 3,00 g | medizinisches Weißöl (Shell: Ondina Öl G 33) |

werden in einem Kneter (Brabender Plasticorder) bei 80 U/min und einer Temperatur von 120 °C homogenisiert. Die erhaltene klare Masse wird anschließend in einer Plattenpresse zwischen zwei 0,125 mm dicken Polyesterfolien bei 120 °C 1,5 min/15 bar und dann 2 min/35 bar auf 3 mm Gesamtschichtdicke gepreßt. Von den Folien ist eine mit einer Haftschicht und die andere mit einer wasserlöslichen oder in organischen Lösemitteln löslichen Anti-Tack-Schicht versehen. Haft- und Anti-Tack-Schicht sind dabei auf der Seite, die der photopolymerisierbaren Masse zugewandt ist. Nach 20 s Rückseitenbelichtung wird die Deckfolie abgezogen. Dann wird das Aufzeichnungsmaterial mit einer aufgelegten Photomaske 8 min in einem UV-A-Flachbelichter bildmäßig belichtet und anschließend in einem Flachbürstenentwicklungsgerät bei 60 °C innerhalb von 8 min entschichtet. Als Entwickler wird dabei eine 1-prozentige Natronlauge, der 5 % Na-Dodecylbenzolsulfonat zugesetzt sind, verwendet.

Die nachbelichtete Druckplatte weist eine Shore-A-Härte von 35 (30 s) auf und ergibt in Wasser, in Ethanol bzw. einem Gemisch aus 85 Teilen Ethanol und 15 Teilen Ethylacetat Quellungswerte von 2,27 %, 4,79 % sowie 14,5 %.

In der gleichen Weise werden die Flexodruckplatten der Beispiele 2 bis 10 hergestellt. Die Zusammensetzung der Beschichtungsmassen und die Eigenschaften dieser Druckplatten ergeben sich aus den Tabellen I und II. Die Druckplatten gemäß den Beispielen 1 bis 10 wurden mit unterschiedlichen Flüssigkeiten gemäß Tabelle III zu entschichten versucht. Die Fälle, bei denen eine Entschichtung stattfindet, sind mit +, die Fälle in denen keine Entschichtung erfolgt, sind mit - gekennzeichnet, während o für eine teilweise Entschichtung steht.

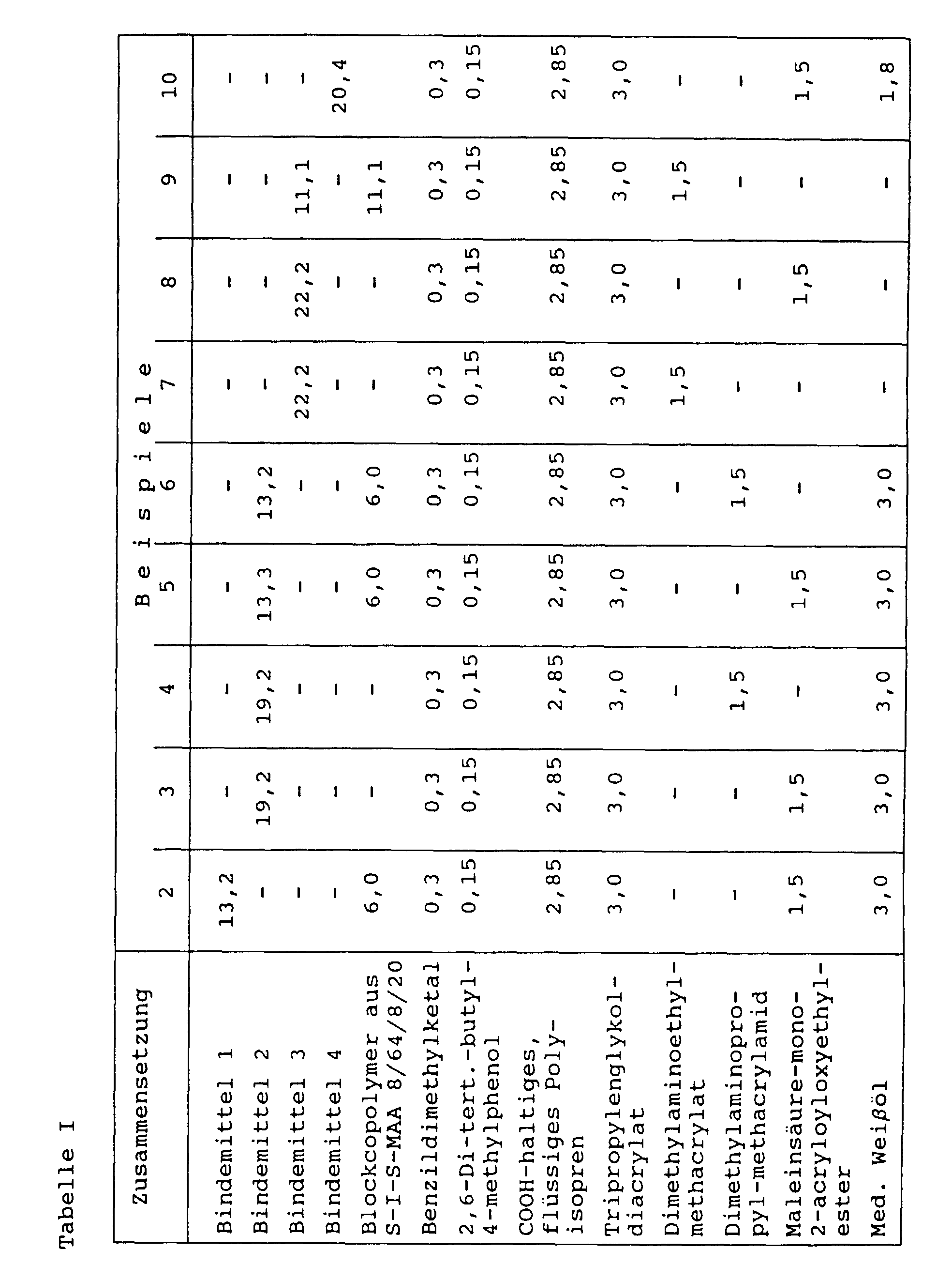

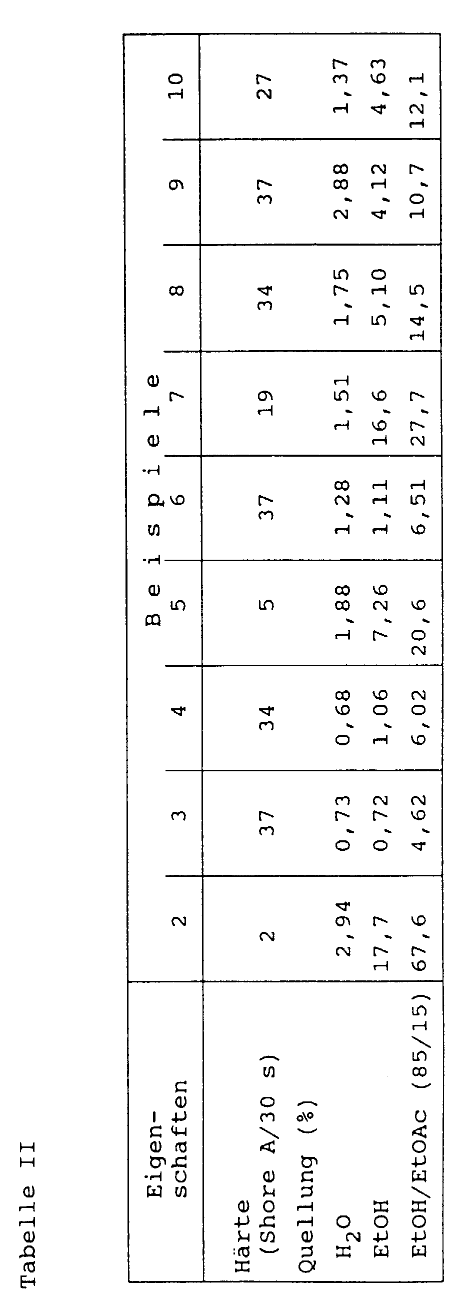

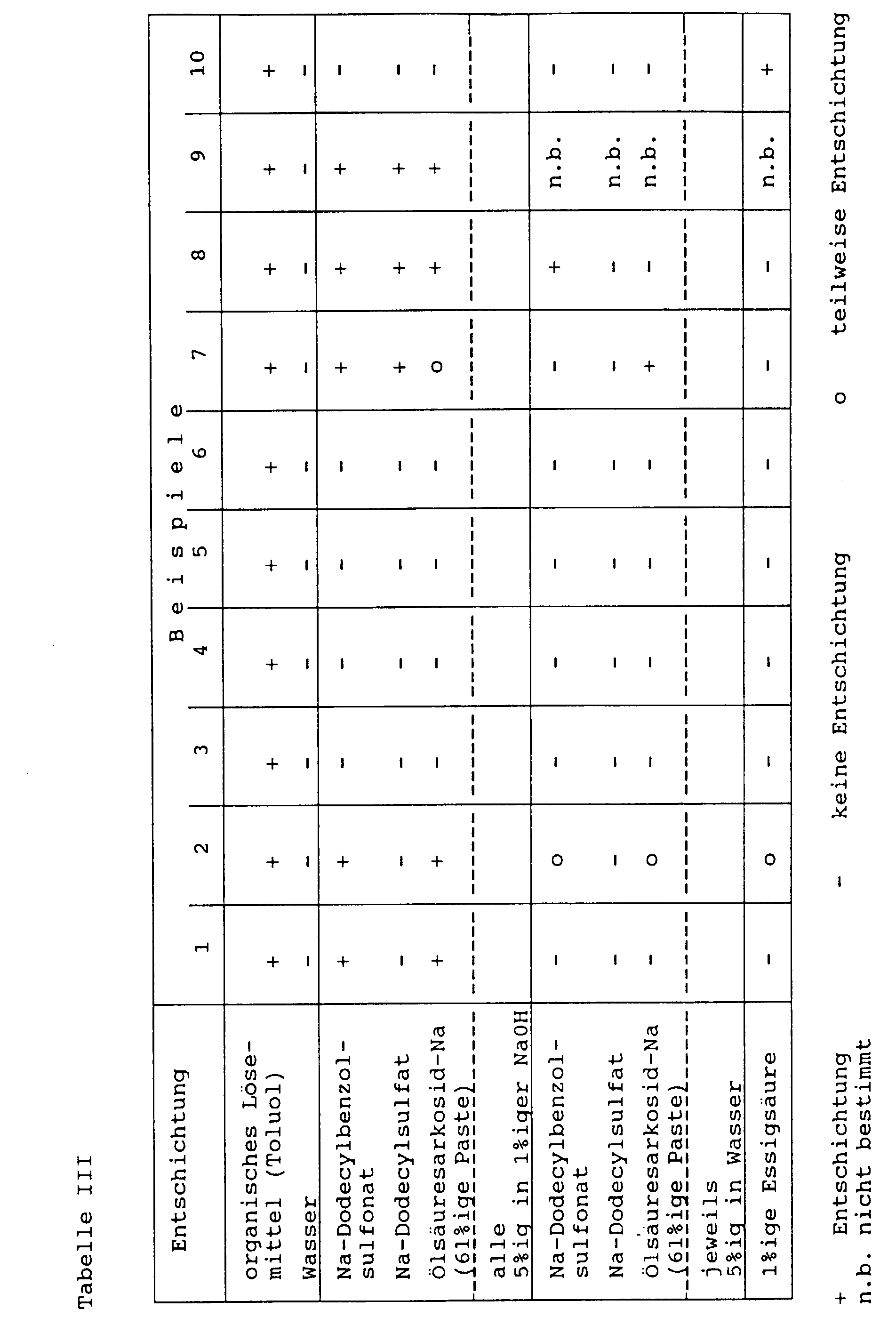

### Beispiel 11 (Offsetdruckplatte)

Eine Beschichtungslösung aus

| | |
|---|---|
| 6,59 g | des gemäß Herstellungsbeispiel 2 synthetisierten I-S-DMAE-MAA-Blockcopolymeren mit einem Anteil von 16 % Styrol, 74 % Isopren und 10 % N,N-Dimethylaminoethylmethacrylat, |
| 6,59 g | Trimethylolpropan-triacrylat, |
| 0,12 g | Phenylacridin, |
| 0,14 g | Samaronmarineblau HR (Disperse Blue 290), |
| 0,12 g | Dibenzalaceton und |
| 86,4 g | Tetrahydrofuran |

wurde auf einen 0,3 mm starken in Salpetersäure aufgerauhten, in Schwefelsäure anodisierten und mit einer 0,1%igen wäßrigen Lösung von Polyvinylphosphonsäure nachbehandelten Aluminiumträger aufgebracht. Das Schichtgewicht betrug 5,5 g/m². Die Platte wurde anschließend mit einer 3,5%igen wäßrigen Lösung eines Polyalkylenoxid-Polyvinylalkohol-Pfropfpolymeren (Hoechst: ^{(R)}Mowiol 04/Ml) überzogen (Schichtgewicht nach dem Trocknen 0,8 g/m²). Die erhaltene Druckplatte wurde mit einer 5-kW-Metallhalogenidlampe im Abstand von 110 cm 40 s unter einem Belichtungskeil sowie verschiedenen anderen Testelementen aus Mikrolinien und Spitzpunktfeldern belichtet. Nach der Belichtung wurde die Platte mit einem Entwickler (5%iges Na-Ölsäuresarkosid in einer 1%igen Natriumcarbonatlösung) mit einem Plüschtampon behandelt.

Die nichtbelichteten Schichtbereiche wurden innerhalb weniger Sekunden sauber entfernt, wobei eine Kopie mit sehr hoher Auflösung und guter Farbannahme erhalten wurde.

## Patentansprüche

1. Lichthärtbares elastomeres Gemisch, das als wesentliche Bestandteile
a) ein elastomeres Bindemittel bzw. Bindemittelgemisch,
b) eine radikalisch polymerisierbare, mit dem Bindemittel verträgliche Verbindung mit mindestens einer endständigen, ethylenisch ungesättigten Gruppe und einem Siedepunkt bei Normaldruck oberhalb 100 °C und
c) eine Verbindung oder eine Verbindungskombination, die unter Einwirkung von aktinischem Licht die Polymerisation der Verbindung (b) einzuleiten vermag,
enthält, dadurch gekennzeichnet, daß das elastomere Bindemittel ein in Wasser oder einer wäßrigen Lösung lösliches oder dispergierbares Blockcopolymerisat ist, das aus den Segmenten A, B, C und X aufgebaut ist, und
A einen hydrophoben weichen Block mit einer Glastemperatur T_{g} von unter -30 °C,
B einen hydrophilen, basische Gruppen enthaltenden harten Block mit einer Glastemperatur T_{g} von über +10 °C,
C einen hydrophoben harten Block mit einer Glastemperatur T_{g} von über +50 °C und
X eine Einheit, gebildet aus einer Verbindung mit zwei oder mehreren Vinyl- oder Isopropenylgruppen oder einem aus solchen Verbindungen entstandenen Homopolymerisatblock, der verzweigt oder vernetzt ist,
bedeuten.

2. Lichthärtbares elastomeres Gemisch nach Anspruch 1, dadurch gekennzeichnet, daß das als Bindemittel dienende elastomere Blockcopolymerisat zu 20 bis 99 Gew.-% aus den Polymerblöcken A, zu 1 bis 30 Gew.-% aus den Polymerblöcken B, 0 bis 79 Gew.-% aus den Polymerblöcken C und zu 0 bis 5 Gew.-% aus dem Block X besteht.

3. Lichthärtbares elastomeres Gemisch nach Anspruch 1, dadurch gekennzeichnet, daß in dem als Bindemittel dienenden elastomeren Blockcopolymerisat die weichen Polymerblöcke A aus konjugierten Dienen, die harten Polymerblöcke B aus ethylenisch α,β-ungesättigten Aminoverbindungen und die harten Polymerblöcke C aus Vinylaromaten gebildet sind.

4. Lichthärtbares elastomeres Gemisch nach Anspruch 3, dadurch gekennzeichnet, daß das konjugierte Dien 1,3-Butadien, Isopren oder 2,3-Dimethyl-1,3-butadien ist.

5. Lichthärtbares elastomeres Gemisch nach Anspruch 3, dadurch gekennzeichnet, daß die ethylenisch α,β-ungesättigte Aminoverbindung ein Dimethylaminoalkylmethacrylat ist.

6. Lichthärtbares elastomeres Gemisch nach Anspruch 3, dadurch gekennzeichnet, daß der Vinylaromat Styrol oder Vinylnaphthalin ist.

7. Lichthärtbares elastomeres Gemisch nach Anspruch 1, dadurch gekennzeichnet, daß das Segment X aus 1,4-Divinylbenzol, 1,3-Diisopropenylbenzol, Ethylenglykoldimethacrylat oder Trimethylolpropantrimethacrylat aufgebaut ist.

8. Lichthärtbares elastomeres Gemisch nach Anspruch 1, dadurch gekennzeichnet, daß das als Bindemittel dienende Blockcopolymerisat ein Molekulargewicht zwischen 15 000 und 200 000 g/mol besitzt.

9. Lichthärtbares elastomeres Gemisch nach Anspruch 1, dadurch gekennzeichnet, daß die radikalisch polymerisierbare Verbindung ein Ester oder Amid der Acryl-, Methacryl-, Fumar- oder Maleinsäure mit einem ein- oder mehrwertigen Alkohol oder Amin ist.

10. Lichthärtbares elastomeres Gemisch nach Anspruch 1, dadurch gekennzeichnet, daß es 20 bis 95 Gew.-% elastomeres Blockcopolymerisat, 5 bis 70 Gew.-% polymerisierbare Verbindungen und 0,01 bis 10 Gew.-% Photopolymerisationsinitiator enthält.

11. Lichthärtbares Aufzeichnungsmaterial mit einem Schichtträger und einer lichthärtbaren Schicht, dadurch gekennzeichnet, daß die lichthärtbare Schicht aus einem Gemisch gemäß einem der Ansprüche 1 bis 9 besteht.

## Claims

1. Light-curable elastomeric mixture containing as the substantial constituents
a) an elastomeric binder or binder mixture,
b) a free-radically polymerisable compound compatible with the binder having at least one terminal, ethylenically unsaturated group and a boiling point at standard pressure of above 100°C and
c) a compound or combination of compounds which, under the action of actinic light, is capable of initiating polymerisation of compound (b),
characterised in that the elastomeric binder is a block copolymer soluble or dispersible in water or an aqueous solution, is synthesised from the segments A, B, C and X and
A means a hydrophobic soft block having a glass transition temperature T_{g} of below -30°C,
B means a hydrophilic hard block containing basic groups and having a glass transition temperature T_{g} of above +10°C,
C means a hydrophobic hard block having a glass transition temperature T_{g} of above +50°C and
X means a unit formed from a compound having two or more vinyl or isopropenyl groups or from a branched or crosslinked homopolymer block produced from such compounds.

2. Light-curable elastomeric mixture according to claim 1, characterised in that the elastomeric block copolymer acting as the binder consists of 20 to 99 wt.% of polymer blocks A, 1 to 30 wt.% of polymer blocks B, 0 to 79 wt.% of polymer blocks C and 0 to 5 wt.% of block X.

3. Light-curable elastomeric mixture according to claim 1, characterised in that, in the elastomeric block copolymer acting as the binder, the soft polymer blocks A are formed from conjugated dienes, the hard polymer blocks B are formed from ethylenically α,β-unsaturated amino compounds and the hard polymer blocks C are formed from vinyl aromatics.

4. Light-curable elastomeric mixture according to claim 3, characterised in that the conjugated diene is 1,3-butadiene, isoprene or 2,3-dimethyl-1,3-butadiene.

5. Light-curable elastomeric mixture according to claim 3, characterised in that the ethylenically α,β-unsaturated amino compound is a dimethylaminoalkyl methacrylate.

6. Light-curable elastomeric mixture according to claim 3, characterised in that the vinyl aromatic is styrene or vinylnaphthalene.

7. Light-curable elastomeric mixture according to claim 1, characterised in that segment X is synthesised from 1,4-divinylbenzene, 1,3-diisopropenylbenzene, ethylene glycol dimethacrylate or trimethylolpropane trimethacrylate.

8. Light-curable elastomeric mixture according to claim 1, characterised in that the block copolymer acting as the binder has a molecular weight of between 15000 and 200000 g/mol.

9. Light-curable elastomeric mixture according to claim 1, characterised in that the free-radically polymerisable compound is an ester or amide of acrylic, methacrylic, fumaric or maleic acid with a mono- or polyfunctional alcohol or amine.

10. Light-curable elastomeric mixture according to claim 1, characterised in that it contains 20 to 95 wt.% of elastomeric block copolymer, 5 to 70 wt.% of polymerisable compounds and 0.01 to 10 wt.% of photopolymerisation initiator.

11. Light-curable recording material having a layer support and a light-curable layer, characterised in that the light-curable layer consists of a mixture according to one of claims 1 to 9.

## Revendications

1. Mélange élastomère durcissable à la lumière qui contient comme constituants essentiels
a) un liant ou mélange de liants élastomère amphiphile,
b) un composé compatible avec le liant, polymérisable par voie radicalaire, ayant au moins un groupe éthyléniquement insaturé terminal et un point d'ébullition à la pression normale supérieur à 100°C
et
c) un composé ou une combinaison de composés qui est capable de provoquer sous l'effet d'une lumière actinique la polymérisation du composé (b),
caractérisé en ce que le liant élastomère est un copolymère séquencé soluble ou dispersable dans l'eau ou dans une solution aqueuse qui est constitué à partir des segments A, B, C et X, et
A représentent une séquence molle hydrophobe ayant une température de transition vitreuse T_{g} inférieure à -30°C,
B représentent une séquence dure hydrophile contenant des groupes basiques ayant une température de transition vitreuse T_{g} supérieure à +10°C,
C représentent une séquence dure hydrophobe ayant une température de transition vitreuse T_{g} supérieure à +50°C et
X représentent une unité, formée à partir d'un composé ayant deux ou plusieurs groupes vinyle ou isopropényle ou à partir d'une séquence d'homopolymère formée à partir de tels composés, qui est ramifiée ou réticulée.

2. Mélange élastomère durcissable à la lumière selon la revendication 1, caractérisé en ce que le copolymère séquencé élastomère qui sert de liant consiste à raison de 20 à 99 % en masse en les séquences de polymère A, à raison de 1 à 30 % en masse en les séquences de polymère B, à raison de 0 à 79 % en masse en les séquences de polymère C et à raison de 0 à 5 % en masse en la séquence X.

3. Mélange élastomère durcissable à la lumière selon la revendication 1, caractérisé en ce que, dans le copolymère séquencé élastomère qui sert de liant, les séquences de polymère molles A consistent en diènes conjugués, les séquences de polymère dures B consistent en composés amino éthyléniquement α,β-insaturés et les séquences de polymère dures C consistent en composés vinylaromatiques.

4. Mélange élastomère durcissable à la lumière selon la revendication 3, caractérisé en ce que le diène conjugué est le 1,3-butadiène, l'isoprène ou le 2,3-diméthyl-1,3-butadiène.

5. Mélange élastomère durcissable à la lumière selon la revendication 3, caractérisé en ce que le composé amino éthyléniquement α,β-insaturé est un méthacrylate de diméthylaminoalkyle.

6. Mélange élastomère durcissable à la lumière selon la revendication 3, caractérisé en ce que le composé vinylaromatique est le styrène ou le vinylnaphtalène.

7. Mélange élastomère durcissable à la lumière selon la revendication 1, caractérisé en ce que le segment X est constitué à partir de 1,4-divinylbenzène, de 1,3-diisopropénylbenzène, de diméthacrylate d'éthylèneglycol ou de triméthacrylate de triméthylolpropane.

8. Mélange élastomère durcissable à la lumière selon la revendication 1, caractérisé en ce que le copolymère séquencé qui sert de liant possède une masse moléculaire comprise entre 15 000 et 200 000 g/mol.

9. Mélange élastomère durcissable à la lumière selon la revendication 1, caractérisé en ce que le composé polymérisable par voie radicalaire est un ester ou amide de l'acide acrylique, méthacrylique, fumarique ou maléique avec un mono- ou polyalcool ou une amine.

10. Mélange élastomère durcissable à la lumière selon la revendication 1, caractérisé en ce qu'il contient 20 à 95 % en masse de copolymère séquencé élastomère, 5 à 70 % en masse de composés polymérisables et 0,01 à 10 % en masse d'amorceur de photopolymérisation.

11. Matériau d'enregistrement durcissable à la lumière comportant un support de couches et une couche durcissable à la lumière, caractérisé en ce que la couche durcissable à la lumière consiste en un mélange selon l'une des revendications 1 à 9.
